# EUROPEAN PATENT APPLICATION

(11) **EP 1 059 537 A2**
(43) Date of publication of application: **13.12.2000**
(21) Application number: 00108831.9
(22) Date of filing: 26.04.2000
(51) Int. Cl.: G01R 31/02, G01R 31/28, H02H 3/16

(54) **Electrically powered apparatus with electronic safety control**

(30) Priority: 11.06.1999 IT PN990048
(71) Applicant: ELECTROLUX PROFESSIONAL S.P.A., 33170 Pordenone (IT)
(72) Inventor: Marson, Vittorio, 30029 S. Stino di Livenza, Venezia (IT); Cenedese, Claudio, 33037 Pasian di Prato, Udine (IT)
(74) Representative: Busca, Luciano

(57) **Abstract**

Apparatus adapted to be connected to a power supply mains (8) and comprising an electronic control unit (5) that is connected to a user interface (6). A toroid (10) is coupled with the power supply mains (8) and drives the electronic control unit (5) with a signal that is representative of possible leakage currents in the apparatus (4). An alarm device (7) is operated in response to a leakage current being substantially different from zero.

## Description

The present invention refers to an electrically powered apparatus of the household or commercial type, such as for instance a refrigeration or similar appliance, which is provided with an electronic safety control that is adapted to detect possible degradations of the electric circuitry of the same apparatus.

Commonly used power distribution networks, or mains systems, are generally known to be based on the practice according to which the neutral conductor is directly connected to earth in a transformer substation, whereas the masses of the loads may be either connected to an earthing or grounding system that is electrically independent of the neutral conductor one (in the so-called "TT" systems) or they may be connected to the earthing system of the neutral conductor by means of a protection conductor (in the so-called "TN" systems). In any case, the currents that circulate in the phase and neutral circuits under normal operating conditions tend to compensate each other (first principle of Kirchhoff), so that their summation is nil. In particular, this means that, under correct operating conditions, there shall be no current circulating between the mass of the loads and earth.

During the operation of electrically powered apparatuses in general, however, various failure or incorrect conditions (as brought about for instance by a deterioration or degradation of the electrical insulation) may actually occur, so that at least an active or live conductor (generally identified as L1, L2, L3 or N) may come into contact with the mass of the apparatus, thereby giving rise to a passage of a current that flows towards the earthing circuit. Such a current is called "fault current" or "leakage current". This current is most obviously an undesired occurrence and may be dangerous, since a part thereof can flow through the body of a person that might be or lie in contact with the mass of the apparatus operating under such failure conditions.

The above described circumstance is well-known both in the technical literature and in practical experience, and safety regulations clearly indicate the precautionary measures that need to be taken in view of reducing any risk situation deriving therefrom for humans.

In this connection, the differential circuit-breaker (generally known also by the name of "life protector switch") is a safety device adapted to cut off the power supply to a device, apparatus or installation when a dangerous situation of leakage current arises. Such a differential circuit-breaker, which is a mandatory provision in all residential and industrial power systems and installations, mainly comprises a toroid provided on the power supply line of the room or site where an electrical apparatus has to be installed. Such a toroid is arranged in such a manner as to ensure that, under regular conditions, the magnetic field generated therein is nil, whereas, in the case of a leakage current, the vectorial summation of the phase and neutral currents has a finite value that produces, on the coil of the toroid, an induced voltage that drives the circuit-breaker into opening, thereby cutting off the power supply.

The occurrence of leakage currents in electrically powered apparatuses is a relatively common event and is basically connected, as already stated earlier in this description, to a reduction in the effectiveness of the insulation between live parts of the circuits (ie. phases and neutral) and the masses of the apparatuses themselves. Such an occurrence can take place owing to a sudden failure (such as for instance a conductor wire coming loose and entering into contact with the mass), but most frequently it happens in a gradual manner, owing for instance to an aging of the insulation or a degradation thereof brought about by moisture depositing on it.

On the other hand, the differential circuit-breaker only trips when the leakage current exceeds a pre-determined, relatively high value (eg., 30 mA in residential power supply installations), while it simply fails to anyway indicate that a leakage process is taking place in an installation or apparatus until said pre-determined value is actually reached. In any case, a tripping of the differential circuit-breaker causes the operation of all electrically powered apparatuses possibly connected to the same installation to be temporarily interrupted, ie. shut off, with clearly negative consequences. Cited in this connection might for instance be the de-energization of a deep-freezer or similar apparatus, which may even last a rather long period of time in the absence of the user and can therefore cause the food or similar items stored in the same apparatus to undergo irretrievable spoilage.

Such an inconvenience is still worse in the case in which (as this occurs for instance in a professional kitchen) there are more apparatuses that are controlled by a single differential circuit-breaker. In such a case, there arises a further drawback connected to the difficulty of understanding in which ones and how many of the apparatuses an electric failure has actually taken place.

On the other hand, the problem of leakage currents is relatively frequent just in moist environments, such as professional kitchen, canteens and similar catering establishments, in which the emission of considerable amounts of vapours promotes water condensation on insulating parts.

It therefore is a main purpose of the present invention to provide an electrically powered apparatus equipped with an electronic safety control adapted to indicate any possible gradual degradation in the integrity of the circuitry of the same apparatus before a substantial failure, or anyway a failure that is capable of causing a differential circuit-breaker to trip, can actually take place.

A further purpose of the present invention is to provide an electrically powered apparatus of the above cited kind with which, in the case that other similar apparatuses are used or installed in the same place, it is possible to timely and easily find out in which one of the same apparatuses an irregular electric condition is actually arising.

According to the present invention, these aims are reached in an electrically powered apparatus provided with an electronic safety control having the characteristics as recited in the appended claims.

Anyway, features and advantages of the present invention can more readily be understood from the description that is given below by way of non-limiting example with reference to the accompanying drawings, in which:
- Figure 1 is a basic wiring diagram of an electric apparatus according to the present invention;
- Figure 2 is a schematical view of an example of embodiment of a display panel to be installed in or used in conjunction with the apparatus illustrated in Figure 1; and
- Figure 3 is a view of a preferred embodiment of an electronic safety circuit to be installed in or used in conjunction with the apparatus illustrated in Figure 1.

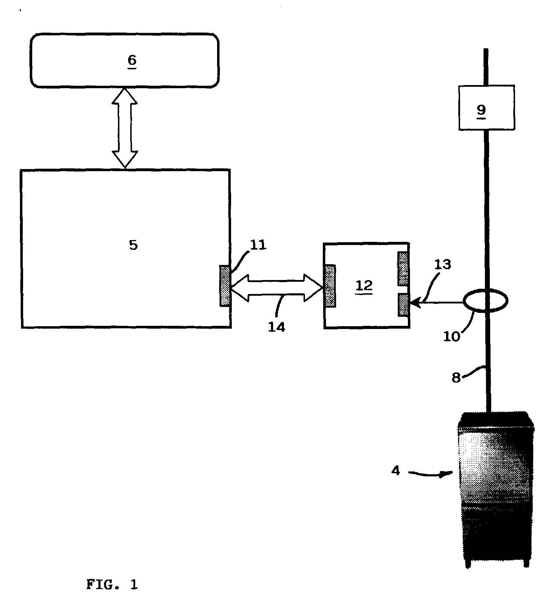

Referring now in particular to Figure 1, the electrically powered apparatus 4 is for example a refrigeration appliance, or the like, of a residential or commercial type.

In a preferred manner, furthermore, the apparatus is of the per sè known type provided with electronic control means 5 adapted to be driven, for instance, with analogue signals by one or more sensors, as well as connected in a bi-directional manner with a so-called "user interface" 6.

Said control means 5 can be substantially implemented as described for instance in the Italian patent application PN99 A 000029, and may include a microprocessor of the Motorola 6805B32 type.

The above cited sensors (not shown for reasons of greater simplicity) may for instance comprise temperature probes, in the case that the apparatus is a refrigeration appliance or the like.

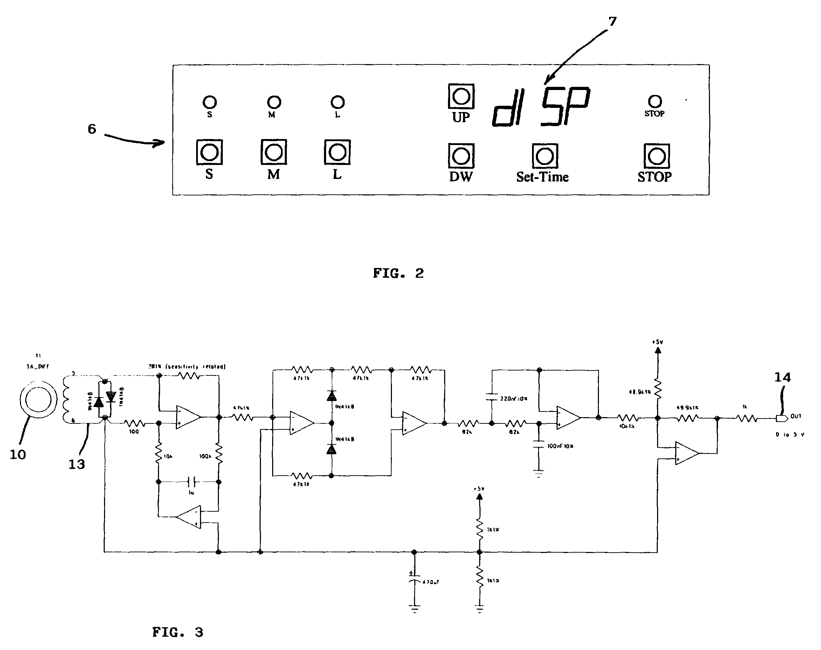

The interface 6 is shown schematically in Figure 2 and preferably comprises a control and setting panel through which it is possible for the operating parameters of the apparatus to be set, as well as for determined operating conditions and/or alarm situations thereof to be indicated, eg. by means at least a LED display device 7 or the like.

The apparatus 4 is connected to a power supply mains, which is schematically indicated at 8 in Figure 1 and is preferably provided with at least a differential circuit-breaker 9 which in a per sè known manner is adapted to cut off the same power supply mains 8 when it detects a leakage current in excess of a pre-determined value I.

The mains 8 comprises of course a certain number of electric conductors, which are not illustrated in the Figures. According to the cases, in particular, the mains 8 comprises at least a phase conductor, a protection conductor (known also as PEN) and possibly a neutral conductor.

According to a feature of the present invention, the apparatus 4 comprises at least a toroid 10, or the like, that is coupled electro-magnetically with the power supply mains 8 and is adapted to drive an input 11 of the control means 5 through a board 12 for the measurement and the amplification of the possible leakage current.

In particular, the toroid 10 is connected to an input 13 of the board 12, whose output 14 drives the input 11 of the control means 5. A possible appropriate circuit schematics of the board 12 and the coupling thereof with the toroid 10 is illustrated by way of example in Figure 3.

The above cited electro-magnetic coupling is brought about by leading the phase conductors and the possible neutral conductor within the toroid 10, while on the contrary leaving the protection conductor outside the same toroid.

Under regular operating conditions, the vectorial summation of the currents in the phase and neutral conductors of the mains 8 gives a resulting current that is nil (first principle of Kirchhoff), so that the magnetic field generated in correspondence of the toroid 10 will also be nil.

Should on the contrary a leakage current toward earth occur in the apparatus 4, the vectorial summation of the phase and neutral currents will have a finite value and produce, in correspondence of the toroid 10, an induced voltage which is a function of the leakage current.

In other words, the toroid 10 is able to drive in a continuous manner the input 11 of the control means 5 with an analogue signal that is representative of the possible leakage current in the apparatus 4.

According to a further feature of the present invention, through the board 12 the control means 5 are arranged so as to be able to measure the above mentioned analogue signal (after a suitable analogue-to-digital conversion) and actuate at least an alarm device 7 when the signal received at the drive input 11 is substantially different from zero, ie. when it exceeds a pre-determined threshold value.

This threshold value will be lower than the one at which the differential circuit-breaker 9 is due to trip. For instance, in a residential installation the differential circuit-breaker will be rated so as to cut off the power supply mains 8 in response to a leakage current of approx. 30 mA, whereas the control means 5 will be adapted to actuate the alarm device 7 in response to a leakage current of approx. 10 mA. Therefore, the apparatus according to the present invention is capable of indicating (eg. by means of the display 7) the existence of a faulty condition giving rise to leakage current well in advance of the same fault eventually aggravating to such an extent as to cause the differential circuit-breaker 9 to trip. It is therefore possible for adequate action to be timely taken so as to repair the faulty condition before the apparatus 4 is eventually de-energized by the differential circuit-breaker 9.

Furthermore, in the case that several apparatuses 4 according to the present invention are connected to the same power supply line 8, it will be readily possible to find out, through the control means 5, in which one, or in which ones, of said apparatuses a faulty condition is actually developing.

It will of course be appreciated that the above described apparatus may be subject to a number of modifications without departing from the scope of the present invention.

For instance, the toroid 10 may be advantageously implemented so as to be able to open apart, such as for instance in the case of the so-called "clips" that are normally used to measure leakage current on power lines. This would enable the devices 10-14 to be supplied as optional component parts of the apparatus, which therefore will be able to be quickly and easily connected in the above described manner.

Furthermore, the control means 5 and the user interface 6 may be arranged in such a manner as to be able to display the value of the possibly detected leakage current, or the possibility may be given to drive alarm devices based on the absolute value or the differential value of the measurement that has been carried out.

## Claims

1. Apparatus adapted to be connected to a power supply mains and comprising electronic control means having at least a driving input and connected to user interface means, **characterized in that** it further comprises sensor means (10) that are coupled with said power supply mains (8) and are adapted to drive said input (11) of the control means (5) with a signal that is representative of possible leakage currents in the apparatus (4), said control means (5) being adapted to trigger at least an alarm device (7) when the signal received at the driving input (11) is substantially different from zero.

2. Apparatus according to claim 1, **characterized in that** said sensor means (10) are connected to the driving input (11) of the control means (5) through at least a device (12) for the measurement and amplification of said leakage current signal.

3. Apparatus according to claim 1, **characterized in that** said sensor means comprise a toroid (10) that is coupled electro-magnetically with said power supply mains (8).

4. Apparatus according to claim 3, in which the power supply mains comprises at least a phase conductor and possibly a neutral conductor, **characterized in that** the phase and neutral conductors are led to run through said toroid (10).

5. Apparatus according to claim 4, in which the power supply mains also comprises a protection conductor, **characterized in that** the protection conductor is led to run outside said toroid (10).

6. Apparatus according to claim 1, in which said power supply mains comprises at least a differential circuit-breaker adapted to cut off the power supply mains in response to a leakage current in excess of a pre-determined threshold value, **characterized in that** said control means (5) are adapted to trigger the alarm device (7) when the signal received at the driving input (11) thereof is representative of a leakage current having a value that is lower than said threshold value.

7. Compressor according to any of the preceding claims, **characterized in that** the ratio of the highest power-supply frequency (f_{T}) to the lowest power-supply frequency (f₁) of the driving motor (10) thereof is comprised between 1.4 and 2.1 and is preferably anywhere near 2.

8. Compressor according to any of the preceding claims, **characterized in that** the means that are adapted to generate said input signal are programmable by the user so as to be able to take the installation conditions and/or any particular design feature of the refrigeration appliance into due account.
